(19) Europäisches Patentamt / European Patent Office / Office européen des brevets

(11) **EP 4 765 635 A1**

(12) **DEMANDE DE BREVET EUROPEEN**

(43) Date de publication:
**24.06.2026 Bulletin 2026/26**

(21) Numéro de dépôt: **25225109.5**

(22) Date de dépôt: **18.12.2025**

(51) Classification Internationale des Brevets (IPC):
**H03H 9/02** (2006.01)     **H03H 9/13** (2006.01)
**H10N 30/40** (2023.01)

(52) Classification Coopérative des Brevets (CPC):
**H03H 9/02157; H03H 9/132; H10N 30/40**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **20.12.2024 FR 2414947**

(71) Demandeur: **Commissariat à l'Énergie Atomique et aux Énergies Alternatives**
**75015 Paris (FR)**

(72) Inventeurs:
• **DESPESSE, Ghislain**
  **38054 GRENOBLE (FR)**
• **REINHARDT, Alexandre**
  **38054 GRENOBLE (FR)**

(74) Mandataire: **Ipsilon**
**12, Avenue d'Italie**
**75013 Paris (FR)**

(54) **RÉSONATEUR PIÉZOÉLECTRIQUE**

(57)    L'invention concerne un résonateur piézoélectrique (10), notamment pour un convertisseur de puissance, comportant :
- Une couche piézoélectrique (20),
- Deux électrodes conductrices (30, 40) s'étendant de part et d'autre de la couche piézoélectrique (20) de sorte que la couche conductrice (20) soit prise en sandwich entre les deux électrodes conductrices (30, 40), chaque électrode conductrice (30, 40) étant délimitée latéralement par une bordure (35, 45) présentant une épaisseur différente de l'électrode correspondante (30, 40), les bordures (35, 45) des deux électrodes (30, 40) étant sensiblement symétriques l'une par rapport à l'autre par rapport à un plan médian M s'étendant au milieu de l'épaisseur $e_{piezo}$ de la couche piézoélectrique (20).

[Fig 1]

Fig. 1

# Description

La présente invention concerne les résonateurs piézoélectriques, notamment pour convertisseurs de puissance, les convertisseurs de puissance comportant de tels résonateurs et un procédé d'utilisation de tels résonateurs dans les convertisseurs de puissance.

## Domaine technique

Les convertisseurs de puissance sont aujourd'hui omniprésents dans notre quotidien, ils permettent d'alimenter l'ensemble de nos dispositifs électroniques nomades ou non. Nécessaires pour l'ensemble de nos appareils électroniques, on cherche à les rendre à la fois plus petits, moins générateurs de pertes et plus performants.

Une des solutions proposées consiste à augmenter leur fréquence de fonctionnement afin de réduire le volume des composants de stockage d'énergie transitoire (c'est-à-dire les passifs). Cependant, des limites subsistent à cette montée en fréquence. Elles s'observent notamment du côté des composants à stockage magnétique qui possèdent des pertes fer intrinsèques et sont soumis au phénomène d'effet de peau, les deux phénomènes empirant lorsque la fréquence augmente. Ceci nuit à l'amélioration de l'efficacité des convertisseurs de puissance.

Afin de répondre à ce problème, l'emploi de résonateurs piézoélectriques a été proposé. Ces résonateurs sont utilisés notamment entre leur fréquence de résonance et d'antirésonance sur un mode propre de la structure (par exemple radial, longitudinal, épaisseur, cisaillement...). Entre ces deux fréquences, ils possèdent des caractéristiques similaires à celles des inductances magnétiques que l'on cherche à remplacer. Les modes de résonance exploités sont de nature mécanique. Ainsi, la structure mécanique du résonateur est à prendre en compte, car celle-ci peut être à l'origine de fuites d'ondes vers l'extérieur du résonateur (donc de pertes), mais aussi comporter des modes de résonance non souhaités pouvant parasiter le système dans sa bande de fréquence de travail/de fonctionnement.

Il est alors crucial de trouver une structure de résonateur présentant un mode principal de résonance à fort coefficient de couplage électromécanique, afin de favoriser l'échange d'énergie entre le résonateur et le circuit électrique autour, et avec un facteur de qualité élevé et le minimum de modes parasites ou des modes parasites les moins couplés possibles dans la bande de fréquence de travail. En outre, l'onde acoustique doit rester confinée dans le résonateur et se propager le moins possible vers l'extérieur.

Les résonateurs piézoélectriques sont utilisés dans de nombreux domaines, notamment pour les filtres acoustiques, notamment pour la radiofréquence, les résonateurs à ondes de volume, notamment ceux utilisant des matériaux comme le quartz servant de base de temps (horloges atomiques). L'état de l'art dans le domaine des résonateurs piézoélectriques a été largement influencé par des travaux antérieurs sur ces domaines. Des solutions ont été proposées dans le domaine de la radiofréquence. On cite par exemple celles décrites dans les travaux de J. Kaitila, "3C-1 Review of Wave Propagation in BAW Thin Film Devices - Progress and Prospects," 2007 IEEE Ultrasonics Symposium Proceedings, New York, NY, USA, 2007, pp. 120-129, doi: 10.1109/ULTSYM.2007.43 qui se concentrent sur l'utilisation de structures comportant un substrat piézoélectrique recouvert d'un côté d'une électrode d'épaisseur constante et s'étendant sur toute sa longueur, et de l'autre côté d'une électrode d'étendue réduite recouvrant uniquement la partie active du résonateur et présentant une bordure épaissie (appelée *frame* ou *border-ring* en anglais). Kaitila explique notamment que l'inertie apportée par l'électrode dans la zone active permet d'abaisser la fréquence de résonance du résonateur dans cette zone par rapport à la fréquence du même mode de vibration à l'extérieur de la zone active, ce qui permet de confiner dans les limites de la zone active le mode de vibration. La bordure épaissie a pour objectif de faciliter l'établissement d'un mode de résonance d'amplitude homogène sur toute la zone intérieure à cette bordure en facilitant la transition entre la zone active interne du résonateur et la zone externe. A l'extérieur du résonateur, la vibration n'est pas totalement nulle, mais drastiquement atténuée, limitant la propagation d'ondes vers l'extérieur et donc la perte d'énergie associée et les risques de réflexion de ces ondes et les résonances parasites associées. Cette bordure, qui n'est présente que d'un côté, introduit également des contraintes mécaniques et des défis de fabrication, notamment en raison des différences de coefficients de dilatation thermique entre les matériaux. De plus, il existe une conversion de l'énergie vers des modes indésirables du fait de la présence des bordures épaissies sur un seul des côtés, générant ainsi le problème des modes parasites supplémentaires, notamment des modes de cisaillement ou longitudinaux d'ordre supérieur.

En alternative à la bordure épaissie, il est également connu des bordures amincies dans l'article R. Thalhammer and J. D. Larson, "Finite element analysis of BAW devices: Principles and perspectives," in Proceedings of the 2015 IEEE International Ultrasonics Symposium. L'analyse et les problématiques sont similaires à celles ci-dessus dans le cas de la bordure épaissie.

T. Wu, H-y Luo, Y.-w Feng, J.-f Bao and K.-y Hashimoto, "Ultra-wideband longitudinally coupled-resonator filters on lithium niobate using periodically slotted SiO2 as an acoustic coupler", Japanese Journal of Applied Physics vol. 63, 02SP87 (2024) décrit également, de façon alternative aux résonateurs décrits dans les travaux de Kaitila précités, deux structures de résonateur couplées entre elles par une structure intermédiaire et avec une excitation électrique séparée pour les deux structures de résonateur. Une des deux structures de résonateur est similaire à la structure décrite par Kaitila dans l'article précité et l'autre présente, de part et d'autre du substrat piézoélectrique, des électrodes s'étendant sur toute la surface du substrat, l'électrode opposée à l'autre structure de résonateur comportant les mêmes surépaisseurs que les bordures de l'autre structure de résonateur. Un tel résonateur présente des surépaisseurs symétriques de part et d'autre de la structure cela réduit la présence des modes parasites supplémentaires dus aux bordures et évite le dépôt épais de matériaux en répartissant la surépaisseur de part et d'autre du résonateur. Néanmoins, la structure est complexe de par la nécessité d'avoir deux structures de résonateurs avec des excitations électriques séparées.

Ces solutions ont été développées pour le domaine des radiofréquences, pour lequel la problématique d'épaisseur de la bordure reste faible de par les faibles dimensions des résonateurs. Le domaine des convertisseurs de puissance nécessite des épaisseurs de la couche piézoélectrique plus importantes par rapport aux filtres radiofréquences, d'un facteur de 100 à 1000, en lien avec le rapport des fréquences de fonctionnement des composants. La surépaisseur de la bordure étant sensiblement proportionnelle à l'épaisseur de la couche piézoélectrique, un dimensionnement homothétique des bordures est nécessaire, ce qui rend la problématique du dépôt épais de matériaux plus importante et problématique que dans le domaine des radiofréquences. Il apparait donc que certaines des problématiques détaillées ci-dessus ont plus ou moins d'importance selon les spécificités des domaines techniques d'utilisation des résonateurs piézoélectriques.

Une autre solution proposée par E. Stolt et al., "A Spurious-Free Piezoelectric Resonator Based 3.2 kW DC-DC Converter for EV On-Board Chargers," in IEEE Transactions on Power Electronics, vol. 39, no. 2, pp. 2478-2488, Feb. 2024, doi: 10.1109/TPEL.2023.3334211 implique l'utilisation d'anneaux en court-circuit autour des résonateurs d'un côté. Bien que cette méthode puisse réduire les pertes d'énergie de façon similaire à la bordure épaissie, elle limite la tension applicable aux bornes du résonateur à la tension de claquage au niveau du/des entrefers entre l'anneau et l'électrode du résonateur. Or cet entrefer doit être faible devant l'épaisseur pour que l'anneau joue pleinement son rôle (ici 120 $\mu$m pour 500 $\mu$m d'épaisseur). La tenue électrique en est donc d'autant plus limitée. Par ailleurs, il est nécessaire de rajouter une liaison électrique entre l'électrode supérieure et inférieure de l'anneau, ce qui rajoute une contrainte de fabrication. Par ailleurs, l'écart d'impédance mécanique entre la zone résonateur et la zone anneau étant faible, la largeur nécessaire d'anneau est assez importante pour atteindre un effet similaire à celui du frame par surépaisseur précédent. L'anneau occupe donc une surface non négligeable devant celle du résonateur, réduisant d'autant la densité de puissance atteignable et augmentant l'encombrement latéral du résonateur. Enfin, l'écart d'impédance de la structure piézoélectrique entre la zone résonateur et la zone de l'anneau est imposé par le seul effet du court-circuit électrique, il n'y a donc pas de degrés de liberté pour choisir au mieux cette impédance, notamment au regard de la surface occupée ou des modes parasites.

En somme, malgré les avancées réalisées, les résonateurs piézoélectriques actuels souffrent encore de limitations en termes de performance, d'efficacité et de compacité.

Il existe notamment un besoin pour minimiser encore l'énergie de déformation transmise à l'extérieur du résonateur piézoélectrique et de favoriser le transfert d'énergie à l'intérieur du résonateur sur un unique mode de résonance, tout en réduisant les modes parasites et en limitant l'encombrement du système total, ce qui est important pour la réduction de volume des convertisseurs de puissance en particulier.

Il existe donc un besoin pour des résonateurs piézoélectriques performants, faciles à fabriquer et compacts, notamment dans le cas d'une utilisation dans les convertisseurs de puissance.

**Résumé de l'invention**

L'invention répond à ce besoin à l'aide notamment d'un résonateur piézoélectrique comportant :

-   Une couche piézoélectrique,
-   Deux électrodes conductrices s'étendant de part et d'autre de la couche piézoélectrique de sorte que la couche piézoélectrique soit prise en sandwich entre les deux électrodes conductrices, chaque électrode conductrice étant délimitée latéralement par une bordure présentant une épaisseur différente de l'électrode correspondante,

les bordures des deux électrodes étant sensiblement symétriques l'une par rapport à l'autre par rapport à un plan médian s'étendant au milieu de l'épaisseur de la couche piézoélectrique.

Par « *sensiblement symétriques* », on comprend symétriques l'une par rapport à l'autre avec des tolérances, notamment de fabrication, en matière de dimensions, notamment d'épaisseurs et/ou de largeur, et/ou d'alignement entre elles. La symétrie est notamment à 10% près, mieux à 5% près, encore mieux à 2% près. L'épaisseur et la largeur des deux bordures peuvent être identiques à 10% près, mieux à 5% près, encore mieux à 2% près. Les bordures peuvent être alignées l'une par rapport à l'autre en symétrie par rapport au plan médian à 10% près, mieux à 5% près, encore mieux à 2% près. Pour préserver la symétrie, les deux bordures sont idéalement en des matériaux identiques.

Par « *délimitée latéralement* », on comprend que l'électrode est confinée ou limitée sur ses bords par une bordure située à proximité. Cette bordure est préférentiellement en contact avec le bord de l'électrode ou se superpose à celui-ci, formant ainsi une limite latérale qui détermine l'étendue de la surface active de l'électrode. Une tolérance de proximité peut être autorisée, permettant à la bordure de se situer à une distance du bord de l'électrode, tout en conservant l'intégrité de la délimitation latérale selon les spécifications du dispositif.

L'absence d'espace entre l'électrode et la bordure permet d'éviter une rupture d'impédance mécanique supplémentaire qui serait liée à un espace intermédiaire. En limitant ainsi les ruptures d'impédance, on limite les risques d'un transfert d'énergie sur des modes de résonance non souhaités.

Le résonateur comporte ainsi :

- une zone de travail définie par la zone de superposition de la couche piézoélectrique et des électrodes,
- une zone de bordure définie par la zone de superposition de la couche piézoélectrique et les bordures et présentant une épaisseur différente de celle de la zone de résonateur, et
- une zone externe définie hors des deux autres zones.

Les avantages techniques de cette configuration sont multiples.

Un tel résonateur permet notamment un confinement des ondes acoustiques dans la zone de travail. La symétrie des bordures des électrodes permet de confiner les ondes à l'intérieur de la zone de travail, réduisant ainsi les pertes d'énergie dues à la propagation des ondes vers l'extérieur, notamment vers la zone externe. Cela améliore l'efficacité globale du résonateur.

En délimitant latéralement les électrodes avec des bordures sensiblement symétriques, l'invention minimise l'excitation de modes de résonance parasites. Cela permet d'obtenir un signal plus pur et de réduire les interférences indésirables, ce qui est crucial pour les applications de haute précision.

La configuration en sandwich de la couche piézoélectrique entre deux électrodes conductrices, avec des bordures sensiblement symétriques, favorise un mode piston à l'intérieur de la zone de travail. Cela signifie que la déformation est sensiblement synchrone et d'amplitude sensiblement homogène, ce qui améliore le couplage électromécanique et l'efficacité de la conversion d'énergie.

Le fait d'avoir des bordures des deux côtés permet notamment de faciliter la fabrication en réduisant la différence d'épaisseur nécessaire par rapport au cas d'une bordure uniquement sur une électrode. En effet, la différence d'épaisseur se répartit alors des deux côtés, réduisant ainsi l'épaisseur de chaque bordure.

En résumé, l'invention propose une solution technique innovante pour améliorer les performances des résonateurs piézoélectriques en termes de confinement des ondes, de réduction des modes parasites, de couplage électromécanique et de facilité de fabrication. Ces avantages rendent l'invention particulièrement adaptée aux applications nécessitant des dispositifs compacts et efficaces, tels que les convertisseurs de puissance et d'autres systèmes électroniques avancés.

De préférence, le résonateur piézoélectrique est pour un convertisseur de puissance.

## Symétrie

De préférence, la zone externe, notamment la couche piézoélectrique, présente une épaisseur inférieure à celle de la zone de résonateur et de la zone de bordure.

Les électrodes peuvent être sensiblement symétriques l'une par rapport à l'autre par rapport au plan médian s'étendant au milieu de l'épaisseur de la couche piézoélectrique.

De préférence, la zone externe et/ou la zone de travail sont sensiblement symétriques par rapport au plan médian s'étendant au milieu de l'épaisseur de la couche piézoélectrique.

Le résonateur peut être sensiblement symétrique par rapport au plan médian s'étendant au milieu de l'épaisseur de la couche piézoélectrique. Cette symétrie permet notamment d'éviter les contraintes mécaniques et les distorsions à l'interface, ce qui améliore la stabilité et la performance du résonateur.

Le résonateur peut être également sensiblement symétrique par rapport à un plan transversal s'étendant perpendiculairement au plan médian. Ceci permet de réduire les modes de résonance parasites qui peuvent interférer avec le fonctionnement du résonateur. En effet, une structure symétrique par rapport au plan transversal empêche l'excitation de modes impairs ($n=1$, 3, ...) en raison de la compensation des charges électriques sur l'ensemble de la surface des électrodes. La symétrie par rapport au plan médian réduit l'excitation des modes pairs ($n=2$, 4, ...). De plus, la présence des bordures réduit également l'excitation de ces modes pairs. Deuxièmement, les bordures aident à maintenir une déformation homogène à l'intérieur du résonateur, ce qui favorise un couplage électromécanique élevé et limite la propagation d'ondes vers l'extérieur, réduisant ainsi les pertes d'énergie. Ces caractéristiques sont particulièrement avantageuses pour la performance et l'efficacité des résonateurs piézoélectriques dans les applications de conversion de puissance.

## Couche piézoélectrique

De préférence, la couche piézoélectrique est monocouche. Elle peut être en un unique matériau sur toute sa superficie et monocouche sur son épaisseur. Cela permet notamment d'éviter d'avoir des interfaces au sein de la couche piézoélectrique qui pourraient générer des déperditions d'énergie.

La couche piézoélectrique peut être en niobate de lithium ($LiNbO_3$), en tantalate de lithium ($LiTaO_3$), en niobate de potassium ($KNbO_3$), en niobate de potassium et de sodium ($KNaNbO_3$), en titanate-zirconate de plomb

(PbZrTiO$_3$), en quartz (SiO$_2$), en nitrure d'aluminium (AlN), en nitrure d'aluminium - scandium (AlScN) et en oxyde de zinc (ZnO). En particulier, dans le cas des convertisseurs de puissance, la couche piézoélectrique est en niobate de lithium (LiNbO$_3$), en tantalate de lithium (LiTaO$_3$), en niobate de potassium (KNbO$_3$), en niobate de potassium et de sodium (KNaNbO$_3$), en titanate-zirconate de plomb (PbZrTiO$_3$) ou en quartz (SiO$_2$).

L'épaisseur de la couche piézoélectrique peut être constante à 1 % près, mieux 0,1% près, au moins dans la zone de résonateur, mieux dans toutes les zones.

La couche piézoélectrique peut présenter une épaisseur supérieure ou égale à 10 $\mu$m, mieux supérieure ou égale à 25 $\mu$m, encore mieux supérieure ou égale à 50 $\mu$m. De telles épaisseurs sont en particulier avantageuses pour des applications de convertisseurs de puissance.

**Electrodes**

Les électrodes peuvent être de mêmes épaisseurs à 20% près, mieux 10% près, encore mieux 5% près.

Les électrodes peuvent présenter chacune une épaisseur constante à 1% près, mieux 0,1% près sur toute leur extension.

Les électrodes peuvent être de contour circulaire, ovale ou polygonal, notamment carré. L'invention n'est pas limitée à une forme particulière des électrodes.

L'épaisseur des électrodes peut être inférieure à l'épaisseur de la couche piézoélectrique, notamment inférieure à un tiers, encore mieux inférieure à un cinquième, de l'épaisseur de la couche piézoélectrique.

**Bordures**

De préférence, les bordures sont chacune en contact avec l'électrode correspondante sur au moins une partie de la périphérie de l'électrode. Elles peuvent être agencées latéralement sur l'électrode correspondante au bord de cette dernière ou à une distance du bord inférieure ou égale à 5 %, mieux 2 % de l'épaisseur de la couche piézoélectrique, ou elles peuvent border latéralement l'électrode correspondante sur tout son pourtour en étant en contact latéralement avec cette dernière sur au moins une partie de son pourtour. Chaque rupture d'impédance referme une surface de dimension différente et chaque dimension permet l'existence de modes de résonance supplémentaires. Par ailleurs, chaque rupture d'impédance facilite la transposition d'un mode de déformation sur un autre mode de déformation et ainsi un transfert d'énergie d'un mode à l'autre. Ainsi, la présence d'un espace entre l'électrode et la bordure augmente le nombre de modes de résonance possibles et facilite le transfert d'énergie du mode principal que l'on recherche vers les autres modes non souhaités. Ainsi, l'absence d'espace entre l'électrode et la bordure permet d'éviter une rupture d'impédance mécanique supplémentaire qui serait liée à un espace intermédiaire. En limitant ainsi les ruptures d'impédance, on limite les risques d'un transfert d'énergie sur des modes de résonance non souhaités.

Les bordures peuvent délimiter les électrodes sur plus de 80%, mieux plus de 90%, encore mieux plus de 95%, de leur périphérie, notamment entièrement.

Dans le cas d'utilisation de matériaux piézoélectriques non isotropes dans le plan, tel que le niobate de lithium (LiNbO$_3$) ou du tantalate de lithium (LiTaO$_3$), il est avantageux d'adapter la largeur de la bordure en fonction de l'orientation de chaque portion élémentaire de bordure par rapport à l'orientation cristalline du matériau. Typiquement, la largeur de la bordure peut être non constante et peut dépendre à chaque endroit de la bordure de la différence entre la direction normale à cette bordure dans le plan du matériau et la direction cristalline du matériau définie dans un même repère à 3 dimensions rattaché au plan du matériau.

De préférence, l'épaisseur des bordures est sensiblement constante.

La largeur et l'épaisseur des bordures sont, de préférence, choisies de sorte que sensiblement un quart d'onde se propage dans la largeur des bordures à une fréquence de travail prédéterminée du résonateur. Cela permet de favoriser le mode piston dans la zone de travail et permet de favoriser une déformation sensiblement synchrone et d'amplitude sensiblement homogène dans la zone de travail.

Les bordures peuvent présenter une largeur comprise entre 5 $\mu$m et 2000 $\mu$m, mieux entre 50 $\mu$m et 1500 $\mu$m, mieux encore entre 50 $\mu$m et 300 $\mu$m dans le cas en particulier d'un convertisseur de puissance.

Les bordures présentent notamment une largeur inférieure ou égale à quatre fois l'épaisseur de la couche piézoélectrique, mieux inférieure ou égale à trois fois l'épaisseur de la couche piézoélectrique, mieux encore inférieure ou égale à la moitié de l'épaisseur de la couche piézoélectrique.

Avantageusement, la largeur des bordures peut être définie à 30% près, mieux 15% près, encore mieux 5% près, selon la formule suivante :

$$k_{frame} \tan( k_{frame} W ) = j k_{ext}$$

où W représente la largeur des bordures et k$_{frame}$ et k$_{ext}$ respectivement le nombre d'onde de la zone de bordure et le nombre d'onde de la zone externe à une fréquence de travail prédéterminée du résonateur pour des épaisseurs de la couche piézoélectrique et des bordures prédéterminées. Cette caractéristique permet notamment d'avoir une précision optimale dans le dimensionnement des bordures du résonateur, ce qui permet en particulier de minimiser les pertes d'énergie et les modes de résonance parasites. En définissant la largeur des bordures avec une précision de 30%, 15%, voire 5%, on s'assure que les bordures sont dimensionnées de manière à maximiser l'efficacité du couplage électromécanique et à confiner les ondes acoustiques à l'intérieur du résonateur. Cela permet également de réduire les risques de déformation et de distorsion, améliorant ainsi la stabilité et la performance globale du résonateur.

La fréquence prédéterminée de travail du résonateur peut être comprise entre la fréquence de résonance et la fréquence d'antirésonance de la zone de travail, notamment être sensiblement le centre géométrique entre la fréquence de résonance et la fréquence d'antirésonance pondérée ou non.

Les bordures peuvent être plus épaisses que les électrodes. La surépaisseur cumulée des deux bordures peut être supérieure ou égale à 1 $\mu$m, mieux supérieure ou égale à 10 $\mu$m.

En variante, les bordures peuvent être plus fines que les électrodes. La sous-épaisseur cumulée des deux bordures peut être supérieure ou égale à 1 $\mu$m, mieux supérieure ou égale à 10 $\mu$m.

Dans un mode de réalisation, les bordures sont en un matériau isolant électriquement, notamment en oxyde ou en nitrure de silicium.

Dans le cas où les bordures sont en un matériau isolant électriquement et où les bordures sont plus épaisses que les électrodes, l'épaisseur des bordures peut être définie pour que, à nombre d'onde nul, la fréquence de résonance de la zone de bordure soit inférieure à la fréquence de résonance de la zone de travail, notamment au moins 3%, mieux au moins 6%, inférieure à la fréquence de résonance de la zone de travail. Et dans le même temps, dans ce cas de figure, la fréquence de résonance de la zone externe doit être supérieure à la fréquence d'antirésonance de la zone de travail, notamment d'au moins 3%, voire mieux d'au moins 6%.

Dans le cas où les bordures sont en un matériau isolant électriquement et où les bordures sont plus fines que les électrodes, l'épaisseur des bordures peut être définie pour que, à nombre d'onde nul, la fréquence de résonance de la zone de bordure soit supérieure à la fréquence d'antirésonance de la zone de travail, notamment au moins 3%, mieux au moins 6 %, supérieure à la fréquence d'antirésonance de la zone de travail.

Dans le cas où les bordures sont en un matériau isolant électriquement, l'épaisseur des bordures est, de préférence, définie pour que, à nombre d'onde nul, la fréquence de résonance de la zone de bordure soit inférieure à la fréquence de résonance de la zone externe.

Dans un autre mode de réalisation, les bordures peuvent être en un matériau électriquement conducteur, notamment le matériau des bordures peut être le même que le matériau de l'électrode correspondante. Elles peuvent être en un métal, notamment en cuivre, nickel, aluminium, molybdène, tungstène, ruthénium, platine, or. Cela permet notamment de faciliter la fabrication et de limiter la présence d'une interface qui pourrait générer une perte d'énergie, par exemple des pertes résistives.

Dans le cas où les bordures sont en un matériau électriquement conducteur et où les bordures sont plus épaisses que les électrodes, l'épaisseur des bordures peut être définie pour que, à nombre d'onde nul, la fréquence de résonance de la zone de bordure soit inférieure à la fréquence de résonance de la zone de résonateur, notamment au moins 3%, mieux au moins 6 %, inférieure à la fréquence de résonance de la zone de résonateur.

Dans le cas où les bordures sont en un matériau électriquement conducteur et où les bordures sont plus fines que les électrodes, l'épaisseur des bordures peut être définie pour que, à nombre d'onde nul, la fréquence d'antirésonance de la zone de bordure soit supérieure à la fréquence d'antirésonance de la zone de résonateur, notamment au moins 3%, mieux au moins 6 %, supérieure à la fréquence d'antirésonance de la zone de résonateur.

Dans le cas où les bordures sont en un matériau électriquement conducteur, l'épaisseur des bordures peut être définie pour que, à nombre d'onde nul, la fréquence d'antirésonance de la zone de bordure soit inférieure à la fréquence de résonance de la zone externe.

## Zone externe

De préférence, le résonateur est dépourvu d'électrode en dehors des zones délimitées par les bordures de part et d'autre de la couche piézoélectrique.

L'épaisseur de la couche piézoélectrique peut être réduite dans la zone externe par rapport à son épaisseur dans la zone de bordure et dans la zone de résonateur.

De préférence, la zone externe est configurée pour que, à nombre d'onde nul, sa fréquence de résonance soit supérieure à la fréquence d'antirésonance de la zone de travail, notamment au moins 3%, mieux au moins 6 %, encore mieux au moins 18%, supérieure à la fréquence d'antirésonance de la zone de résonateur.

## Connection électrique

De préférence, le résonateur comporte des contacts électriques pour relier chacune des électrodes à un circuit électrique, notamment en contact chacun avec une électrode et/ou une bordure. Les contacts électriques de part et d'autre de la couche piézoélectrique sont préférentiellement non superposés. Cela permet d'éviter qu'une vibration de la couche piézoélectrique apparaisse entre ces contacts dans la zone externe. Dans le cas de bordures en surépaisseur et en un matériau conducteur, les contacts électriques peuvent être intégrés dans les bordures et présenter une épaisseur sensiblement égale à la surépaisseur des bordures. Dans le cas de bordures en surépaisseur et en un matériau isolant, les contacts électriques peuvent être intégrés dans la bordure correspondante soit par interruption de la bordure localement, ou par superposition à la bordure localement en passant au-dessus ou en-dessous.

## Double bordure

Le résonateur peut comporter des bordures additionnelles de part et d'autre de la couche piézoélectrique dans la zone externe. Les bordures additionnelles peuvent être sensiblement symétriques l'une par rapport à l'autre par rapport au plan médian s'étendant au milieu de l'épaisseur de la couche piézoélectrique. Les bordures additionnelles peuvent être de largeur et/ou d'épaisseur différente des bordures.

L'invention répond également à ce besoin, au moins en partie, à l'aide d'un convertisseur de puissance comportant le résonateur piézoélectrique tel que décrit précédemment.

## Procédé d'utilisation

L'invention répond également au besoin précité par un procédé d'utilisation du résonateur tel que décrit précédemment comme convertisseur de puissance.

La plage de fréquence de fonctionnement du convertisseur peut être comprise entre la fréquence de résonance et la fréquence d'antirésonance de la zone de travail définie par la zone de superposition de la couche piézoélectrique et des électrodes, la fréquence de résonance et la fréquence d'antirésonance étant définies à nombre d'onde nul.

## Brève description des dessins

[Fig 1] représente schématiquement en coupe transversale un exemple de résonateur piézoélectrique,

[Fig 2] représente schématiquement en coupe transversale une variante de résonateur piézoélectrique,

[Fig 3] représente schématiquement en coupe transversale une variante de résonateur piézoélectrique,

[Fig 4] représente schématiquement en coupe transversale une variante de résonateur piézoélectrique,

[Fig 5] représente schématiquement en coupe transversale une variante de résonateur piézoélectrique,

[Fig 6] représente des courbes de dispersion dans les différentes zones d'un exemple de résonateur piézoélectrique.

[Fig 7] représente schématiquement en coupe transversale une variante de résonateur piézoélectrique, et

[Fig 8] représente schématiquement en vue du dessus une variante de résonateur piézoélectrique.

## Description détaillée

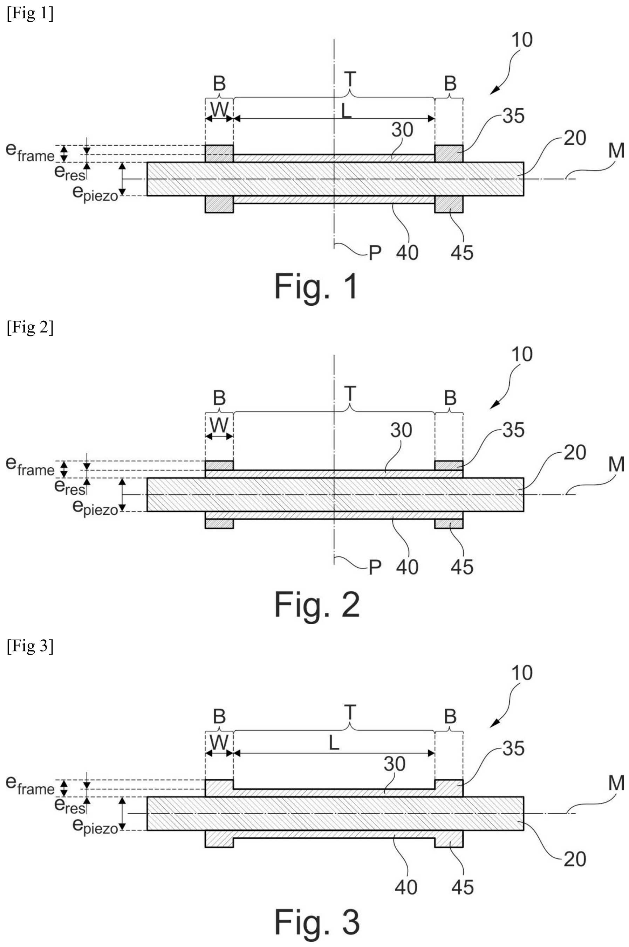

On a illustré à la figure 1 un résonateur piézoélectrique 10 comportant une couche piézoélectrique 20 prise en sandwich entre deux électrodes conductrices 30 et 40. Les deux électrodes 30 et 40 sont délimitées latéralement par des bordures notées respectivement 35 et 45 présentant des épaisseurs différentes des électrodes 30 et 40. Les bordures 35 et 45 de part et d'autre de la couche piézoélectrique 20 sont sensiblement symétriques entre elles par rapport à un plan médian M de la couche piézoélectrique 20. Elles sont ici représentées parfaitement symétriques par rapport au plan médian M, mais il existe bien évidemment une tolérance dans la symétrie permettant néanmoins d'avoir un effet intéressant sur le résonateur 10. Les bordures peuvent être identiques à 20%, mieux 10%, encore mieux 5% près et elles peuvent être positionnées au repère entre elles à 20%, mieux 10%, encore mieux 5% près.

La zone T définie par la superposition de la couche piézoélectrique 20 et des électrodes 30 et 40 (bordures exclues) constitue la zone de travail dans laquelle nous souhaitons confiner les ondes et dans laquelle une déformation synchrone et d'amplitude homogène est recherchée. La ou les zones B définies par la superposition de la couche piézoélectrique 20 et des bordures 35 et 45 constituent la ou les zones de bordures permettant une transition contrôlée de la déformation entre la zone externe et la zone de travail T afin de répondre au besoin de l'invention.

Dans l'exemple illustré, la couche piézoélectrique 20 est monocouche en un unique matériau sur toute sa superficie, ce qui permet notamment d'éviter les interfaces internes susceptibles de générer des déperditions d'énergie. Cependant, il pourrait en être autrement. Elle pourrait notamment être multicouche en un même ou en différents matériaux piézoélectriques. Dans le cas d'une multicouche, elle est dépourvue d'électrodes dans la structure multicouche et les couches sont entre elles de préférence en contact.

La couche piézoélectrique 20 peut être en niobate de lithium ($LiNbO_3$), en tantalate de lithium ($LiTaO_3$), en niobate de potassium ($KNbO_3$), en niobate de potassium et de sodium ($KNaNbO_3$), en titanate-zirconate de plomb ($PbZrTiO_3$), en quartz ($SiO_2$), en nitrure d'aluminium (AlN), en nitrure d'aluminium - scandium (AlScN) ou en oxyde de zinc (ZnO). De préférence, dans le cas des convertisseurs de puissance, la couche piézoélectrique 20 est en niobate de lithium ($LiNbO_3$), en tantalate de lithium ($LiTaO_3$), en niobate de potassium ($KNbO_3$), en niobate de potassium et de sodium ($KNaNbO_3$), en titanate-zirconate de plomb ($PbZrTiO_3$) ou en quartz ($SiO_2$). L'épaisseur $e_{piezo}$ de la couche piézoélectrique 20 est constante à 1% près, mieux 0,1% près, au moins dans la zone de travail T, de préférence sur toute son étendue.

Chaque électrode conductrice 30 ou 40 peut présenter une épaisseur $e_{res}$ constante à 1 % près, mieux 0,1 % près, sur toute son extension. Dans l'exemple illustré, l'épaisseur $e_{res}$ est inférieure à un cinquième de l'épaisseur $e_{piezo}$ de la couche piézoélectrique 20. Les électrodes 30 et 40 peuvent être de contour circulaire, ovale ou polygonal, notamment carré.

Dans l'exemple illustré, les électrodes 30 et 40 sont sensiblement identiques et symétriques par rapport au plan médian M. Il existe bien évidemment une tolérance comme pour les bordures. Les électrodes peuvent être identiques à 20%, mieux 10%, encore mieux 5% près et elles peuvent être positionnées au repère entre elles à 20%, mieux 10%, encore mieux 5% près.

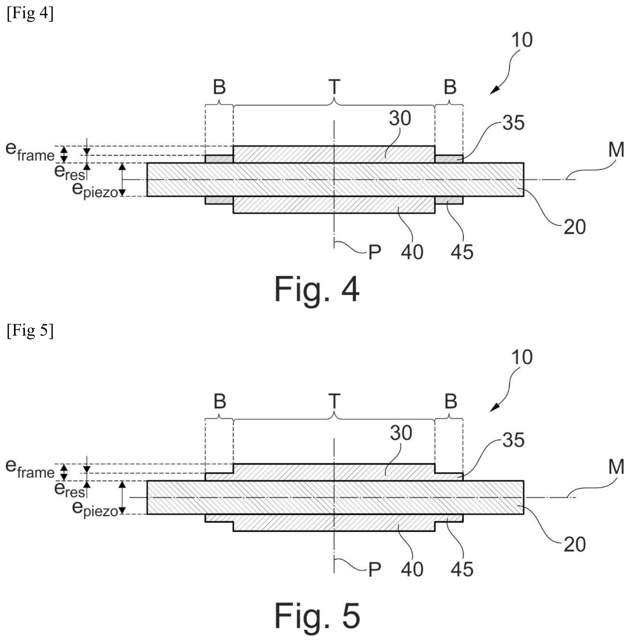

Les bordures 35 et 45 présentent des épaisseurs $e_{frame}$ différentes de l'épaisseur $e_{res}$ des électrodes 30 et 40. Cette épaisseur des bordures $e_{frame}$ peut être supérieure à celle $e_{res}$ des électrodes 30 et 40, comme cela est illustré sur les figures 1 à 3, ou inférieure à celle $e_{res}$ des électrodes 30 ou 40, comme cela est illustré sur les figures 4 et 5.

Les bordures 35 et 45 sont de préférence, chacune, en contact de l'électrode 30 ou 40 correspondante sur au moins une partie de la périphérie de l'électrode 30 ou 40. Les bordures 35 et 45 peuvent délimiter les électrodes 30 et 40 sur plus de 80 %, mieux plus de 90 %, encore mieux plus de 95 %, de leur périphérie, de préférence entièrement.

Elles peuvent border latéralement l'électrode 30 ou 40 correspondante sur tout son pourtour en étant en contact latéralement avec cette dernière sur au moins une partie de son pourtour, comme cela est illustré sur les figures 1 et 4. En variante illustrée sur la figure 2, elles peuvent être avantageusement agencées latéralement sur l'électrode correspondante au bord de cette dernière ou sinon à proximité immédiate du bord, notamment à une distance du bord de moins de 5 %, mieux 2% de l'épaisseur du piézoélectrique.

Le résonateur 10 est préférentiellement dépourvu d'électrode 30 ou 40 en dehors des zones délimitées par les bordures 35 et 45 de part et d'autre de la couche piézoélectrique 20. L'épaisseur $e_{piezo}$ de la couche piézoélectrique 20 peut être réduite dans la zone externe par rapport à son épaisseur dans la zone de bordure B et dans la zone de travail T.

Les électrodes 30 et 40 sont de préférence en un même matériau conducteur, notamment en cuivre, nickel, aluminium, molybdène, tungstène, ruthénium, platine, or.

De préférence, les électrodes et les bordures sont sensiblement symétriques par rapport au plan médian M et à un plan transversal au plan médian P. L'ensemble du résonateur peut présenter de telles symétries par rapport au plan médian M et à un plan transversal P.

Dans le cas de matériaux piézoélectriques non isotropes dans le plan, tels que le niobate de lithium (LiNbO3) ou le tantalate de lithium (LiTaO3), il est avantageux d'adapter la largeur W des bordures 35 et 45 en fonction de l'orientation de chaque portion élémentaire de bordure par rapport à l'orientation cristalline du matériau.

Les bordures 35 et 45 sont préférentiellement d'épaisseur $e_{frame}$ sensiblement constantes sur toute la bordure.

Les bordures 35 et 45 peuvent être du même matériau que l'électrode correspondante, comme illustré sur les figures 3 et 5. Cela permet notamment de faciliter la fabrication et de limiter la présence d'une interface qui pourrait générer une perte d'énergie. En variante illustrée sur les figures 1, 2 et 4, elles peuvent être en un matériau différent. Dans ce dernier cas, elles peuvent être en un matériau conducteur ou isolant.

La largeur W et l'épaisseur $e_{frame}$ des bordures 35 et 45 sont, de préférence, choisies de sorte qu'une fraction d'onde correspondant sensiblement à un quart d'onde se propage dans la largeur des bordures à une fréquence de travail prédéterminée du résonateur $f_{work}$. Cela permet de favoriser le mode piston dans la zone de travail T et permet de favoriser une déformation sensiblement synchrone et d'amplitude sensiblement homogène dans la zone de travail T.

L'épaisseur $e_{frame}$ des bordures 35 et 45 peut être choisie pour avoir un bon compromis entre coût/contraintes de fabrication réduits, notamment plus importants pour des bordures plus épaisses, et le moins possible de modes indésirables excités à la fréquence de travail $f_{work}$. L'épaisseur $e_{frame}$ des bordures 35 et 45 peut être sensiblement indépendante de la largeur L des électrodes 30 et 40.

Avantageusement, la largeur W des bordures 35 et 45 peut être définie à 30% près, mieux 15% près, encore mieux 5% près, selon la formule suivante :

$$k_{frame} \tan( k_{frame}W) = jk_{ext}$$

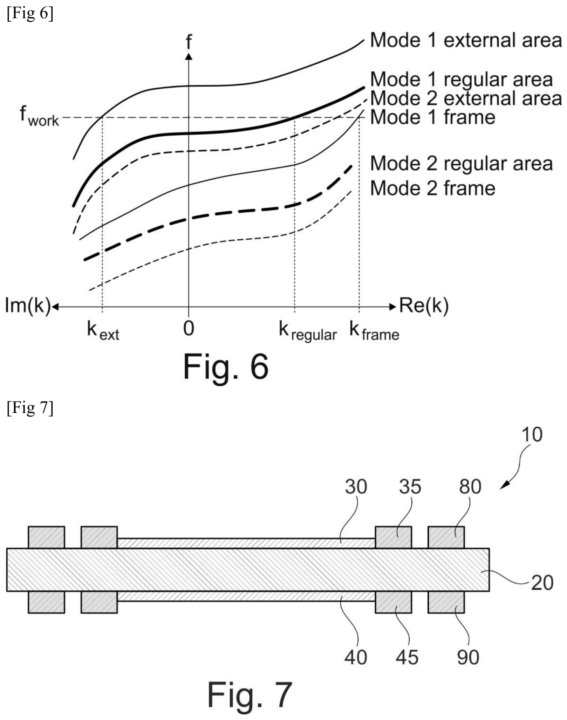

où $k_{frame}$ et $k_{ext}$ respectivement le nombre d'onde de la zone de bordure B et le nombre d'onde de la zone externe à une fréquence de travail prédéterminée du résonateur 10 pour des épaisseurs de la couche piézoélectrique $e_{piezo}$ et des bordures $e_{frame}$ prédéterminées. Les nombres d'ondes peuvent être déterminés à partir de courbes de dispersion prédéterminées, comme illustré sur la figure 6, notamment par simulation par éléments finis périodiques, notamment utilisant des conditions de Bloch-Floquet imposant une relation de phase entre les deux bords du maillage à la fréquence de travail pour les différentes zones. Ces courbes de dispersion peuvent être déterminées pour différents modes (ici modes 1 et 2) pour la zone de travail (regular area), la zone de bordure (frame) et la zone extérieure (external area). La détermination des autres modes permet également de s'assurer que le transfert vers les autres modes parasites, notamment ici le mode 2, reste négligeable. Cette caractéristique permet notamment d'approcher un optimal dans le dimensionnement des bordures du résonateur, ce qui permet en particulier de minimiser les pertes d'énergie et les modes de résonance parasites. En définissant avantageusement la largeur des bordures avec une précision de 30%, 15%, voire 5%, on s'assure que les bordures sont dimensionnées de manière à maximiser l'efficacité du couplage électromécanique et à confiner les ondes acoustiques à l'intérieur du résonateur.

Cela permet également de réduire les risques de déformation et de distorsion, améliorant ainsi la stabilité et la performance globale du résonateur. La largeur de la bordure peut être entre 5 $\mu$m et 2 mm.

En variante, pour une épaisseur $e_{frame}$ de bordure 35 et 45 prédéterminée, la largeur W de la bordure en fonction de la fréquence de travail $f_{work}$ peut être déterminée à partir d'une courbe préétablie de la largeur W déterminée selon l'équation précédente en fonction de la fréquence de travail $f_{work}$. Il est alors possible de se référer uniquement à des abaques de la largeur optimale en fonction de la fréquence pour différentes épaisseurs de bordures. Ainsi, après détermination de l'épaisseur $e_{frame}$ optimale, il est possible de déterminer facilement la largeur W optimale à la fréquence de travail $f_{work}$ ou la plage de largeur optimale dans la plage de fréquence de travail, notamment entre la fréquence de résonance $f_{res\_s}$ et d'antirésonance $f_{res\_p}$ de la zone de travail T.

La fréquence de travail du résonateur $f_{work}$ peut être comprise entre la fréquence de résonance $f_{res\_s}$ et la fréquence d'antirésonance $f_{res\_p}$ de la zone de travail, notamment être sensiblement le centre géométrique entre la fréquence de résonance $f_{res\_r}$ et la fréquence d'antirésonance $f_{res\_p}$ pondéré ou non.

De préférence, les bordures 35 et 45 présentent une largeur W inférieure ou égale à quatre fois l'épaisseur de la couche piézoélectrique $e_{piezo}$, mieux inférieure ou égale à trois fois l'épaisseur de la couche piézoélectrique $e_{piezo}$, mieux encore inférieure ou égale à la moitié de l'épaisseur de la couche piézoélectrique $e_{piezo}$.

Dans le cas où les bordures 35 et 45 sont en un matériau isolant électriquement et que les bordures 35 et 45 sont plus épaisses que les électrodes 30 et 40, comme illustré sur les figures 1 à 3, l'épaisseur $e_{frame}$ de ces bordures est définie pour que, à nombre d'onde nul, la fréquence de résonance $f_{frame}$ de la zone de bordure B soit inférieure à la fréquence de résonance $f_{ext}$ de la zone externe. L'épaisseur $e_{frame}$ des bordures peut, de plus, être définie pour que, à nombre d'onde nul, la fréquence de résonance $f_{frame}$ de la zone de bordure B soit inférieure à la fréquence de résonance $f_{res\_s}$ de la zone de travail T, notamment au moins 3 %, mieux au moins 6 %, inférieure à la fréquence de résonance $f_{res\_s}$ de la zone de travail T. Si elles sont plus fines que les électrodes 30 et 40, comme illustré sur les figures 4 et 5, l'épaisseur des bordures $e_{frame}$ peut être définie pour que, à nombre d'onde nul, la fréquence de résonance de la zone de bordure $f_{frame}$ soit supérieure à la fréquence d'antirésonance de la zone de travail $f_{res\_p}$, notamment au moins 3 %, mieux au moins 6 %, supérieure à la fréquence d'antirésonance de la zone de travail $f_{res\_p}$.

Dans le cas où les bordures 35 et 45 sont en un matériau électriquement conducteur et que les bordures 35 et 45 sont plus épaisses que les électrodes 30 et 40, comme illustré sur les figures 1 à 3, l'épaisseur $e_{frame}$ des bordures est, de préférence, définie pour que, à nombre d'onde nul, la fréquence de résonance $f_{frame\_s}$ de la zone de bordure B soit inférieure à la fréquence de résonance de la zone de résonateur $f_{res\_s}$, notamment au moins 3 %, mieux au moins 6 %, inférieure à la fréquence de résonance de la zone de résonateur $f_{res\_s}$. Si elles sont plus fines que les électrodes 30 et 40, l'épaisseur des bordures $e_{frame}$ peut être définie pour que, à nombre d'onde nul, la fréquence d'antirésonance de la zone de bordure $f_{frame\_p}$ soit supérieure à la fréquence d'antirésonance de la zone de travail $f_{res\_p}$, notamment au moins 3 %, mieux au moins 6 %, supérieure à la fréquence d'antirésonance de la zone de travail $f_{res\_p}$.

Dans ces deux cas, de préférence, la zone externe est configurée pour que, à nombre d'onde nul, sa fréquence de résonance $f_{ext}$ soit supérieure à la fréquence d'antirésonance de la zone de travail $f_{res\_p}$, notamment au moins 3 %, mieux au moins 6 %, encore mieux au moins 18 %, supérieure à la fréquence d'antirésonance de la zone de travail $f_{res\_p}$.

Les dimensions sont également dépendantes de la fréquence de travail $f_{work}$ et donc de l'application. Typiquement, pour un convertisseur de puissance, la couche piézoélectrique 20 présente une épaisseur $e_{piezo}$ supérieure ou égale à 50 $\mu$m, les électrodes présentent une épaisseur $e_{res}$ supérieure ou égale à 1 $\mu$m, par exemple de l'ordre de la dizaine de micromètre, et l'épaisseur et les bordures 35 et 45 peuvent présenter une surépaisseur ou une sous-épaisseur $e_{frame}$ de l'ordre de quelques micromètres et une largeur W comprise entre 5 $\mu$m et 2000 $\mu$m, mieux entre 50 $\mu$m et 1500 $\mu$m, mieux encore entre 50$\mu$m et 300$\mu$m.

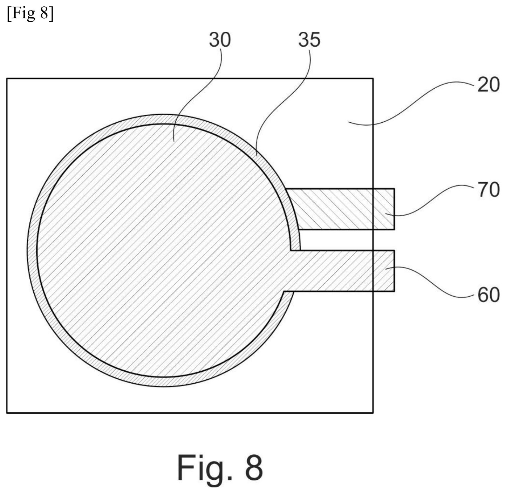

Le résonateur 10 comporte en outre des contacts électriques 60 et 70 pour relier chacune des électrodes à un circuit électrique, notamment en contact chacun avec une des électrodes 30 et 40 et/ou une bordure 35 et 45. Les contacts électriques 60 et 70 de part et d'autre de la couche piézoélectrique 20 sont préférentiellement non superposés. Cela permet d'éviter qu'une vibration de la couche piézoélectrique 20 n'apparaisse entre ces contacts 60 et 70 dans la zone externe. De tels contacts électriques 60 et 70 sont représentés en figure 8.

Dans le cas de bordures 35 et 45 en surépaisseur et en un matériau conducteur, les contacts électriques 60 et 70 peuvent être intégrés dans les bordures 35 et 45 et présenter une épaisseur sensiblement égale à la surépaisseur des bordures. Dans le cas de bordures en surépaisseur et en un matériau isolant, les contacts électriques peuvent être intégrés dans la bordure correspondante soit par interruption de la bordure localement, ou, par superposition à la bordure localement en passant au-dessus ou en-dessous.

Le mode de réalisation illustré sur la figure 7 diffère de celui de la figure 1 en ce que le résonateur 10 peut comporter des bordures additionnelles 80 et 90 de part et d'autre de la couche piézoélectrique 20 dans la zone externe. Les bordures additionnelles 80 et 90 peuvent être sensiblement symétriques l'une par rapport à l'autre par rapport au plan médian M. Les bordures additionnelles 80 et 90 peuvent être de même largeur et épaisseur que les bordures 35 et 45. En variante, elles pourraient être de largeur et/ou d'épaisseur différente des bordures 35 et 45.

**Exemple de dimensionnement**

Dans un exemple de mise en œuvre selon l'invention illustré sur la figure 1 pour un convertisseur de puissance, la couche piézoélectrique est de $500\,\mu$m d'épaisseur en LNO (niobate de lithium) d'orientation cristalline Y36° par rapport aux électrodes, les électrodes 30 et 40 sont de contour circulaire et sont de 15 $\mu$m d'épaisseur. Elles sont bordées par des bordures 35 et 45 de 30 $\mu$m d'épaisseur et de 1,2mm de largeur, jointes aux électrodes. Ce résonateur est utilisé sur une plage de travail autour de 6MHz. Le résonateur est parfaitement symétrique par rapport à un plan médian de la couche piézoélectrique et par rapport à un plan médian perpendiculaire à ce plan médian.

L'invention n'est pas limitée aux modes de réalisation qui viennent d'être décrits. Les caractéristiques peuvent être combinées lorsque cela est techniquement possible. Par ailleurs, comme mentionné, il existe une tolérance de dimensions et/ou positionnements des éléments entre eux permettant d'avoir des performances intéressantes, si ce n'est équivalentes.

**Revendications**

1. Résonateur piézoélectrique (10), notamment pour un convertisseur de puissance, comportant :

    - Une couche piézoélectrique (20),
    - Deux électrodes conductrices (30, 40) s'étendant de part et d'autre de la couche piézoélectrique (20) de sorte que la couche piézoélectrique (20) soit prise en sandwich entre les deux électrodes conductrices (30, 40), chaque électrode conductrice (30, 40) étant délimitée latéralement par une bordure (35, 45) présentant une épaisseur différente de l'électrode correspondante (30, 40),
    les bordures (35, 45) des deux électrodes (30, 40) étant sensiblement symétriques l'une par rapport à l'autre par rapport à un plan médian M s'étendant au milieu de l'épaisseur $e_{piezo}$ de la couche piézoélectrique (20).

2. Résonateur selon la revendication 1, comportant

    - une zone de travail T définie par la zone de superposition de la couche piézoélectrique (20) et des électrodes (30, 40),
    - une zone de bordure B définie par la zone de superposition de la couche piézoélectrique (20) et les bordures (35, 45) et présentant une épaisseur différente de celle de la zone de travail T, et

    - une zone externe définie hors des deux autres zones B et T.

3. Résonateur selon la revendication 2, dans lequel la zone externe présente une épaisseur $e_{piezo}$ inférieure à celle de la zone de travail T et de la zone de bordure B.

4. Résonateur selon l'une quelconque des revendications précédentes, dans lequel le résonateur est sensiblement symétrique par rapport au plan médian M s'étendant au milieu de l'épaisseur $e_{piezo}$ de la couche piézoélectrique (20).

5. Résonateur selon l'une quelconque des revendications précédentes, dans lequel l'épaisseur $e_{piezo}$ de la couche piézoélectrique et l'épaisseur $e_{res}$ des électrodes est constante à 1 % près, mieux 0,1% près, au moins dans la zone de résonateur, mieux dans toutes les zones.

6. Résonateur selon l'une quelconque des revendications précédentes, dans lequel les bordures (35, 45) sont chacune en contact avec l'électrode (30, 40) correspondante sur au moins une partie de la périphérie de l'électrode, notamment sur tout leur pourtour.

7. Résonateur selon l'une quelconque des revendications précédentes, dans lequel la couche piézoélectrique (20) présente une épaisseur $e_{piezo}$ supérieure ou égale à 10 $\mu$m, mieux supérieure ou égale à 25 $\mu$m, encore mieux supérieure ou égale à 50 $\mu$m et les bordures (35, 45) présentent une largeur W inférieure ou égale à quatre fois l'épaisseur $e_{piezo}$ de la couche piézoélectrique (20), mieux inférieure ou égale à trois fois l'épaisseur $e_{piezo}$ de la couche piézoélectrique (20), mieux encore inférieure ou égale à la moitié de l'épaisseur $e_{piezo}$ de la couche piézoélectrique (20), notamment comprise entre 5 $\mu$m et 2000 $\mu$m, mieux entre 50$\mu$m et 1500$\mu$m, mieux encore entre 50$\mu$m et 300$\mu$m.

8. Résonateur selon l'une quelconque des revendications précédentes, dans lequel la largeur W et l'épaisseur $e_{frame}$ des bordures (35, 45) sont choisies de sorte qu'un quart d'onde se propage dans la largeur W des bordures (35, 45) à une fréquence de travail prédéterminée $f_{work}$ du résonateur.

9. Résonateur selon l'une quelconque des revendications précédentes, dans lequel la largeur W des bordures (35, 45) est définie à 30% près, mieux 15% près, encore mieux 5% près, selon la formule suivante :

$$k_{frame} \tan( k_{frame} W) = jk_{ext}$$

où W représente la largeur des bordures (35, 45) et $k_{frame}$ et $k_{ext}$ respectivement les nombres d'onde de la zone de bordure B et de la zone externe respectivement à une fréquence prédéterminée de travail $f_{work}$ du résonateur pour des épaisseurs de la couche piézoélectrique (20) et des bordures (35, 45) prédéterminées.

10. Résonateur selon la revendication 8 ou 9, dans lequel la fréquence prédéterminée de travail $f_{work}$ du résonateur est comprise entre la fréquence de résonance $f_{res\_s}$ et la fréquence d'antirésonance $f_{res\_p}$ de la zone de travail T, notamment être sensiblement le centre géométrique entre la fréquence de résonance $f_{res\_s}$ et la fréquence d'antirésonance $f_{res\_p}$ pondéré ou non.

11. Résonateur selon l'une quelconque des revendications précédentes, dans lequel les bordures (35, 45) sont en un matériau isolant électriquement, l'épaisseur $e_{frame}$ des bordures (35, 45) étant notamment définie pour que, à nombre d'onde nul, la fréquence de résonance $f_{frame}$ de la zone de bordure soit inférieure à la fréquence de résonance $f_{ext}$ de la zone externe.

12. Résonateur selon la revendication 11, dans lequel les bordures (35, 45) sont plus épaisses que les électrodes (30, 40) et l'épaisseur $e_{frame}$ des bordures (35, 45) est définie pour que, à nombre d'onde nul, la fréquence de résonance $f_{frame}$ de la zone de bordure soit inférieure à la fréquence de résonance $f_{res\_s}$ de la zone de travail, notamment au moins 3%, mieux au moins 6 %, inférieure à la fréquence de résonance $f_{res\_s}$ de la zone de travail.

13. Résonateur selon la revendication 11, dans lequel les bordures (35, 45) sont plus fines que les électrodes (30, 40) et l'épaisseur $e_{frame}$ des bordures (35, 45) est définie pour que, à nombre d'onde nul, la fréquence de résonance $f_{frame}$ de la zone de bordure soit supérieure à la fréquence d'antirésonance $f_{res\_p}$ de la zone de travail, notamment au moins 3%, mieux au moins 6 %, supérieure à la fréquence d'antirésonance $f_{res\_p}$ de la zone de travail.

14. Résonateur selon l'une quelconque des revendications 1 à 10, dans lequel les bordures (35, 45) sont en un matériau électriquement conducteur, notamment le matériau des bordures (35, 45) peut être le même que le matériau de l'électrode correspondante, l'épaisseur $e_{frame}$ des bordures (35, 45) étant notamment définies pour que, à nombre d'onde nul, la fréquence d'antirésonance $f_{frame\_s}$ de la zone de bordure soit inférieure à la fréquence de résonance $f_{ext}$ de la zone externe.

15. Résonateur selon la revendication 14, dans lequel les bordures (35, 45) sont plus épaisses que les électrodes et l'épaisseur $e_{frame}$ des bordures (35, 45) est définies pour que, à nombre d'onde nul, la fréquence de résonance $f_{frame\_s}$ de la zone de bordure soit inférieure à la fréquence de résonance $f_{res\_s}$ de la zone de résonateur, notamment au moins 3%, mieux au moins 6 %, inférieure à la fréquence de résonance $f_{res\_s}$ de la zone de résonateur.

16. Résonateur selon la revendication 14, dans lequel les bordures (35, 45) sont plus fines que les électrodes et l'épaisseur des bordures (35, 45) est définie pour que, à nombre d'onde nul, la fréquence d'antirésonance $f_{frame\_p}$ de la zone de bordure soit supérieure à la fréquence d'antirésonance $f_{res\_p}$ de la zone de résonateur, notamment au moins 3%, mieux au moins 6 %, supérieure à la fréquence d'antirésonance $f_{res\_p}$ de la zone de résonateur.

17. Résonateur selon l'une quelconque des revendications précédentes, comportant des contacts électriques (60, 70) pour relier chacune des électrodes (30, 40) à un circuit électrique, notamment en contact chacun avec une électrode (30, 40) et/ou une bordure (35, 45), les contacts électriques de part et d'autre de la couche piézoélectrique (20) étant non superposés entre eux.

18. Résonateur selon l'une quelconque des revendications précédentes, comportant des bordures (35, 45) additionnelles de part et d'autre de la couche piézoélectrique (20) dans la zone externe sensiblement symétriques l'une par rapport à l'autre par rapport au plan médian M s'étendant au milieu de l'épaisseur de la couche piézoélectrique.

19. Convertisseur de puissance comportant un résonateur piézoélectrique (10) selon l'une quelconque des revendications précédentes.

20. Procédé d'utilisation du résonateur piézoélectrique selon l'une quelconque des revendications 1 à 18 dans un convertisseur de puissance.

[Fig 1]

Fig. 1

[Fig 2]

Fig. 2

[Fig 3]

Fig. 3

[Fig 4]

Fig. 4

[Fig 5]

Fig. 5

[Fig 6]

Fig. 6

[Fig 7]

Fig. 7

[Fig 8]

Fig. 8

| | | | Europäisches<br>Patentamt<br>European<br>Patent Office<br>Office européen<br>des brevets | **RAPPORT DE RECHERCHE EUROPEENNE** | **Numéro de la demande**<br>EP 25 22 5109 |

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (IPC) |
|---|---|---|---|
| X | EP 4 401 310 A1 (CHANGZHOU CHEMSEMI CO LTD [CN]) 17 juillet 2024 (2024-07-17) | 1-6,8,10 | INV.<br>H03H9/02 |
| A | * alinéa [0197] - alinéa [0200]; figures 5c,9c * | 7,9,<br>11-20 | H03H9/13<br>H10N30/40 |
| | ----- | | |
| A | US 8 791 776 B2 (PANG WEI [CN]; ZHANG HAO [CN]) 29 juillet 2014 (2014-07-29)<br>* figures 1A,1B,1C, 2A,2B,3 * | 1-20 | |
| | ----- | | |

**DOMAINES TECHNIQUES<br>RECHERCHES (IPC)**

H03H
H02N
H10N

Le présent rapport a été établi pour toutes les revendications

| Lieu de la recherche | Date d'achèvement de la recherche | Examinateur |
|---|---|---|
| Munich | 20 avril 2026 | Mesplede, Delphine |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

..............................................................................

& : membre de la même famille, document correspondant

EPO FORM 1503 03.82 (P04C02)

# EP 4 765 635 A1

**ANNEXE AU RAPPORT DE RECHERCHE EUROPEENNE**
**RELATIF A LA DEMANDE DE BREVET EUROPEEN NO.**  EP 25 22 5109

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-04-2026

| Document brevet cité au rapport de recherche | Date de publication | Membre(s) de la famille de brevet(s) | Date de publication |
|---|---|---|---|
| EP 4401310 A1 | 17-07-2024 | CN 113824422 A | 21-12-2021 |
| | | CN 114421916 A | 29-04-2022 |
| | | EP 4401310 A1 | 17-07-2024 |
| | | US 2025141427 A1 | 01-05-2025 |
| | | WO 2023036028 A1 | 16-03-2023 |
| US 8791776 B2 | 29-07-2014 | AUCUN | |

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J. KAITILA**. 3C-1 Review of Wave Propagation in BAW Thin Film Devices - Progress and Prospects. *2007 IEEE Ultrasonics Symposium Proceedings, New York, NY, USA*, 2007, 120-129
- **R. THALHAMMER** ; **J. D. LARSON**. Finite element analysis of BAW devices: Principles and perspectives. *Proceedings of the 2015 IEEE International Ultrasonics Symposium*
- **T. WU** ; **H-Y LUO** ; **Y.-W FENG** ; **J.-F BAO** ; **K.-Y HASHIMOTO**. Ultra-wideband longitudinally coupled-resonator filters on lithium niobate using periodically slotted SiO2 as an acoustic coupler. *Japanese Journal of Applied Physics*, 2024, vol. 63, 02SP87
- **E. STOLT et al.** A Spurious-Free Piezoelectric Resonator Based 3.2 kW DC-DC Converter for EV On-Board Chargers. *IEEE Transactions on Power Electronics*, February 2024, vol. 39 (2), 2478-2488